# EUROPEAN PATENT SPECIFICATION

(11) **EP 0 606 668 B1**
(45) Date of publication and mention of the grant of the patent: **04.03.1998**
(21) Application number: 93200091.2
(22) Date of filing: 15.01.1993
(51) Int. Cl.: H03F 1/52

(54) **Transistor arrangement**
Transistoranordnung
Montage de transistors

(43) Date of publication of application: 20.07.1994
(73) Proprietor: ALCATEL ALSTHOM COMPAGNIE GENERALE D'ELECTRICITE, 75008 Paris (FR)
(72) Inventor: Verkinderen, Johan Gabriel August, B-8820 Torhout (BE); Willocx, Eddie Louis Marie, B-2830 Willebroek (BE)

(56) References cited:
- EP-A- 0 032 985
- EP-A- 0 119 159
- DE-A- 3 322 932
- US-A- 4 319 181
- US-A- 4 771 357
- PATENT ABSTRACTS OF JAPAN vol. 8, no. 119 (E-248)(1556) 5 June 1984 & JP-A-59 33 910

## Description

The present invention relates to a transistor arrangement as defined in the preamble of claim 1.

Such a transistor arrangement can be used for instance in an end stage of an amplifier driving a two-wire communication line for transferring e.g. telephony signals. It is already known in the art, e.g. from US patent 4,682,054 and forms part of a so-called push-pull circuit. It includes a field effect transistor connected between the base and the collector of the bipolar transistor means here constituted by one bipolar transistor, its gate being connected to the input terminal, and with the switching means constituted by a resistor or a transmission switch connected between the base and the emitter of the bipolar transistor. When the voltage at the input terminal decreases, the voltage at the second terminal which in this case is the emitter of the bipolar transistor and constitutes an output of the push-pull circuit, increases and a positive current then flows from the first terminal, i.e. the collector of the bipolar transistor, to the second terminal via this bipolar transistor. The voltage at the output may rise until the base-emitter voltage of the bipolar transistor, i.e. the voltage drop across the resistor or the transmission switch, is reduced to less than about 0.7 volts. Then the bipolar transistor is cut off and the above positive current flows from the first to the second terminal via the field effect transistor and the resistor or the transmission switch. Due to the field effect transistor the output voltage swing is increased because the maximum voltage at the output is no longer limited to about 0.7 volts below the voltage at the base of the bipolar transistor. As a result, the minimum voltage across the bipolar transistor, i.e. between the first and the second terminal, can be about zero volt (depending upon the current to be delivered to the output), and the maximum output voltage swing is equal to the maximum possible voltage across the bipolar transistor. The latter voltage is approximately equal to the collector-emitter breakdown voltage with open base of the bipolar transistor. This maximum voltage between the first and the second terminal can only occur across the bipolar transistor when both this transistor and the field effect transistor are cut off, so that a possible negative current pulse (i.e. in a sense opposite to that of the above positive current) injected in a line connected to the output, e.g. induced therein, can not be delivered or taken up by this known transistor arrangement.
It should be noted that the transmission switch of the known transistor arrangement is permanently conducting and thus operates as a resistor rather than as a real switch.

An object of the present invention is to provide a transistor arrangement of the above known type with an increased maximum output voltage swing but which can also take up current when the bipolar transistor means is cut off.

According to the invention, this object is achieved by the transistor arrangement defined in claim 1.

The switching means being closed when the voltage between the collector and the emitter of the bipolar transistor means exceeds the predetermined value, the maximum voltage across this bipolar transistor means is then constituted by the so-called collector-emitter breakdown voltage with short-circuited base, referred to as BVCES, which, as known in the art, is higher than the collector-emitter breakdown voltage with open base, referred to as BVCEO and applicable in the known arrangement described above. Thus, an increased maximum output voltage swing is possible. Once the switching means is closed the bipolar transistor means can no longer conduct current but this current can then be delivered or taken up by the impedance means connected in parallel with the bipolar transistor means. In this way, a possible negative current pulse as mentioned above can be delivered or taken up by the transistor arrangement.

It is noticed that besides a voltage protection, other protection mechanisms may be foreseen for a bipolar transistor. These other protection mechanisms may be combined with the voltage protection circuit according to the present invention to protect the transistor in different operating regions. One of the protection mechanisms however can not replace the other. The *European Patent Application EP 0 032 985* for instance describes a short circuit protection arrangement which provides transistor protection for overheating whenever the output current of a line driver circuit remains low while the input current thereof is increasing. Such a short-circuit protection arrangement typically contains a current sensing scheme instead of a voltage sensing means, and takes into account a certain delay period before it switches off the transistor to be protected to give the output current the chance to follow the rise of the input current. An alternative short circuit protection mechanism is described in the *United States Patent US 4,771,357.* Yet another protection mechanism for a transistor in a driving device is described in the *Japanese Patent Application JP-A-59-33910, entitled 'Base Circuit of Transistor'.* The arrangement disclosed therein protects a transistor for large displacement currents caused by voltage changes across the collector and emitter terminals of the transistor. It is thereto equipped with a voltage change detector.

A further characteristic feature of the present transistor arrangement is that said impedance means includes a first field effect transistor whose drain-source path is coupled between said first terminal and said second terminal and a gate of which is biased so as to allow said current to flow.

Still another characteristic feature of the present transistor arrangement is that said impedance means includes a second field effect transistor of which the drain-source path is coupled between said first terminal and said second terminal and of which a gate is coupled to said input terminal so as to allow said current to flow.

The gate must be so coupled to the input terminal that the second field effect transistor can take up the above reverse current pulse. Furthermore, the input terminal then has to be coupled to the base of the bipolar transistor means in such a way that the second field effect transistor is still able to conduct a current when the bipolar transistor means is cut off, i.e., depending upon the polarity of both the bipolar transistor means and the second field effect transistor, the signal as applied to the base of the bipolar transistor means has to be inverted or not with respect to that applied to the gate of the second field effect transistor.

A further feature of the present transistor arrangement is that it further includes a third field effect transistor connected between said collector and said base of said bipolar transistor means and a gate of which is biased so as to allow said current to flow.

When the switching means is closed this third field effect transistor provides a second conductive path in parallel with the impedance means and the bipolar transistor means for delivering or taking up reverse current pulses.

Yet a further feature of the present transistor arrangement is that it further includes a fourth field effect transistor connected between said collector and said base of said bipolar transistor means and a gate of which is coupled to said input terminal so as to allow said current to flow.

When the switching means is closed this fourth field effect transistor provides another conductive path in parallel with the impedance means and the bipolar transistor means for delivering or taking up reverse current pulses. The fourth field effect transistor can also be used to invert the signal at the input terminal prior to applying it to the base of the bipolar transistor means, thereby complying with the polarity requirements of the previous feature.

Yet another feature of the present transistor arrangement is that said bipolar transistor means includes a NPN transistor.

Thus, NPN transistors having better frequency characteristics than PNP transistors, an optimal frequency response of the transistor arrangement is obtained.

Further developing the present transistor arrangement, it further includes a second bipolar transistor means a collector-emitter path of which is connected between said second terminal and a third terminal, and a base of which is also coupled to said input terminal, a second switching means connected between said base and an emitter of said second bipolar transistor means, and a second sensing means sensing the voltage between said second terminal and said third terminal and closing said second switching means when the latter voltage exceeds a second predetermined value, and a second impedance means also connected between said second terminal and said third terminal and which is adapted to allow a current to flow from said second terminal to said third terminal when said voltage across the latter terminals exceeds said second predetermined value, and that said second terminal constitutes an output of said transistor arrangement.

Thus, the first mentioned and the second bipolar transistor means together constitute a so-called push-pull circuit which has a large voltage swing at the output. Indeed, this output voltage swing is only limited by the lowest of both collector-emitter breakdown voltages with short-circuited base (BVCES) of the two bipolar transistor means. Furthermore, when both bipolar transistor means are NPN-type transistors a good frequency response is obtained.

In a further embodiment of the present transistor arrangement, said sensing means includes a zener diode coupled in series with a resistor between said first terminal and said second terminal, said resistor being coupled between said zener diode and said second terminal and in that said first mentioned switching means is constituted by a fifth field effect transistor a gate of which is coupled to a coupling node between said resistor and said zener diode.

When the voltage between the first and the second terminal is large enough, i.e. at least larger than the zener voltage of the zener diode, a current starts flowing through this zener diode and the resistor, thus providing a voltage drop across the resistor. When this voltage exceeds the so-called threshold voltage of the fifth field effect transistor the latter is turned on, thereby closing the first switching means. For reasons of polarity, when the first bipolar transistor means is a NPN transistor the fifth field effect transistor is a N-channel transistor, whereas a PNP first bipolar transistor means is combined with a P-channel fifth field effect transistor. The first predetermined value is determined by the zener voltage of the first zener diode. To be noted that a similar circuit may be used for the second switching means mentioned above.

Still an additional characteristic of the present transistor arrangement is that a second zener diode is coupled between said coupling node and said first mentioned zener diode, that a third switching means is connected between said emitter and the junction point between said first zener diode and said second zener diode, said third switching means being closed when the voltage across said resistor exceeds a predetermined threshold value, and that a current mirror circuit is provided to which the current flowing through said first zener diode is input and from which a mirrored current is output to said resistor.

Thus, the first predetermined value for closing the first switching means is a function of the sum of the zener voltages of the first and the second zener diode, but, the third switching means providing a path for the current through the first zener diode when it is closed and the current mirror circuit applying the mirrored current to the resistor, the first predetermined value for opening the first switching means is still a function of the zener voltage of the first zener diode but not of the zener voltage of the second zener diode. Thus, the first switching means opening and closing at different voltages between the first and the second terminal, a hysteresis is provided preventing the first switching means from repetitively switching on and off.

Still another feature of the present transistor arrangement is that said third switching means is constituted by a sixth field effect transistor a gate of which is connected to said coupling node.

When the fifth and the sixth field effect transistor, constituting the first and the third switching means respectively, have the same so-called threshold voltage, and when the voltage across the resistor reaches this threshold voltage, both switching means are closed and the second zener diode has no more purpose until the first and the third switching means are open again due to the voltage between the first and the second terminal falling below the first predetermined value for opening the first switching means.

The above mentioned and other objects and features of the invention will become more apparent and the invention itself will be best understood by referring to the following description of an embodiment taken in conjunction with the accompanying drawings wherein :
Fig. 1 shows a transistor arrangement according to the invention; and
Fig. 2 represents a sensing means used in the transistor arrangement of Fig. 1.

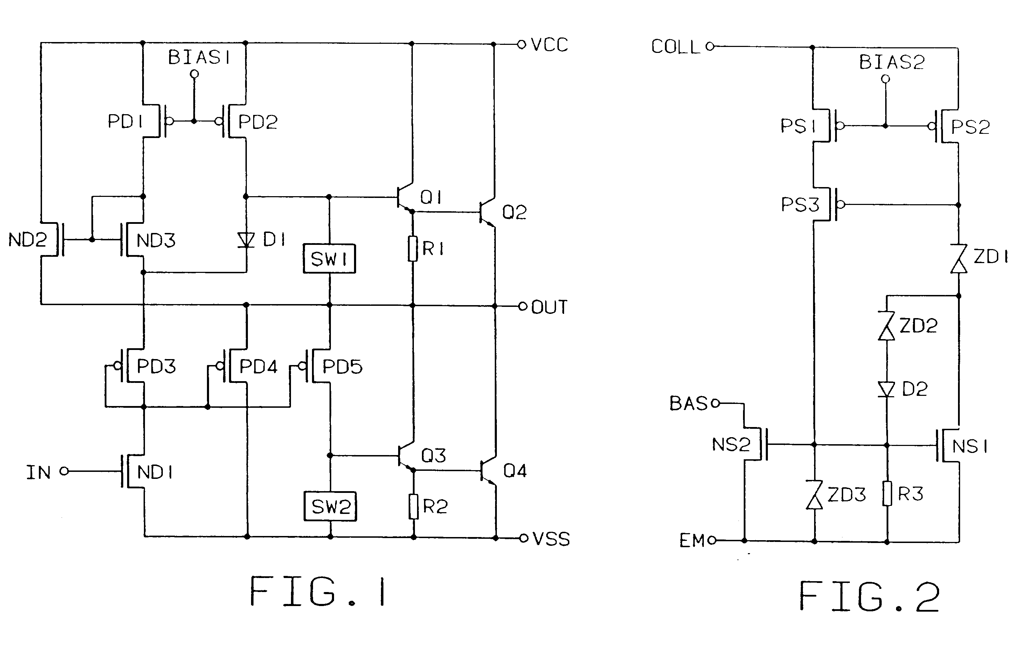

The transistor arrangement of Fig. 1 is used in a final stage of a (not shown) amplifier driving a (not shown) two-wire communication line as used e.g. for transferring telephony signals. Each wire of the two-wire line is connected to an output of one of two like transistor arrangements, one of which is shown in Fig. 1. The two transistor arrangements are oppositely driven for instance by a so-called differential pair providing complementary analog signals to the respective inputs of the two transistor arrangements.

The transistor arrangement shown in Fig. 1 includes the totempole connection of two bipolar transistor means constituted by darlington connected bipolar NPN transistor pairs Q1/Q2 and Q3/Q4 with resistors R1 and R2 biasing the base of transistors Q2 and Q4, respectively. The collectors of Q1 and Q2 are both connected to a first supply terminal VCC at which a like named positive voltage VCC is provided, whereas R2 and the emitter of Q4 are connected to a second supply terminal VSS at which a like named negative voltage VSS is provided. R1, the emitter of Q2 and the collectors of Q3 and Q4 are connected to an output terminal OUT of the transistor arrangement. The base of Q1 is coupled to OUT via a switch or switching means SW1 controlled by a sensing means shown in Fig. 2 and discussed hereinafter, whereas the base of Q3 is coupled to VSS via a switch or switching means SW2 similar to SW1. The base of Q3 is further coupled to OUT via the drain-source path of a PMOS-transistor PD5 the gate of which is coupled, together with the gate of another PMOS-transistor PD4 which is connected between VSS and OUT, to the drain of an NMOS-transistor ND1 the source of which is connected to VSS and the gate of which constitutes an input terminal IN of the transistor arrangement. The drain of ND1 is further coupled to the interconnected gate and drain of a PMOS-transistor PD3 the source of which is connected to the source of an NMOS-transistor ND3. The gate and the drain of ND3 are also interconnected and coupled to VCC via the source-drain path of a PMOS-transistor PD1 the gate of which is connected to a terminal BIAS1 of a biasing voltage source providing a like named biasing voltage BIAS1. BIAS1 is further also connected to the gate of a PMOS-transistor PD2 which is coupled between VCC and the base of Q1. Finally, the base of Q1 is also coupled to the source of ND3 via a diode D1, whilst an NMOS-transistor ND2 is connected between VCC and OUT and has its gate connected to the gate of ND3. To be noted that PD1 and PD2 constitute current sources, that bipolar transistors Q1/Q2 and Q3/Q4 constitute a so-called push-pull circuit well known in the art, and that PD3 in combination with D1 constitutes a so-called level shifter providing a class AB biasing of the push-pull circuit as it is also known in the art.

As already mentioned, the switches SW1 and SW2 are controlled by a sensing means represented in Fig. 2. This sensing means includes two branches coupled between two terminals COLL and EM. A first branch comprises the series connection of the main paths of two PMOS-transistors PS1 and PS3 and a zener-diode ZD3 and is in parallel with a second branch comprising the series connection of a PMOS-transistor PS2, a zener-diode ZD1 and an NMOS-transistor NS1 which acts as a switching means. The gates of PS1 and PS2 are both connected to a terminal BIAS2 of a biasing voltage source providing a like named biasing voltage BIAS2, whereas the gate of PS3 is connected to the drain of PS2, i.e. to the junction point between PS2 and ZD1. The gate of NS1 is coupled to its drain via the series connection of a zener diode ZD2 and a diode D2, and to its source, i.e. to the terminal EM, via the parallel connection of a resistor R3 and the zener diode ZD3. Finally, an NMOS-transistor NS2 whose gate is connected to that of NS1 has its main path connected between the terminal EM and a terminal BAS. NS2 constitutes either the switch SW1 or SW2 of Fig. 1, terminal BAS thus being connected to the base of Q1 or Q3, terminal EM being connected to the emitter of Q2 or Q4, and terminal COLL being connected to the collector of the transistors Q1/Q2 or Q3/Q4, respectively. To be noted that PS1, PS2 and PS3 constitute a current mirror circuit as will become clear from the following description of the operation of the transistor arrangement, this description making reference to both Fig. 1 and Fig. 2.

As mentioned above, the transistor arrangement is used in an amplifier driving a two-wire communication line, each wire of which is connected to an output of one of two like transistor arrangements the inputs of which are driven with respective complementary analog signals.

The analog signal provided to the input IN of the transistor arrangement shown in Fig. 1 modulates the resistance of the source-drain path of ND1 and thereby the voltage at the drain of ND1. When the voltage of the analog signal rises, the resistance of this drain-source path decreases so that the voltage at the drain of ND1 decreases. As a consequence and assuming the voltage at OUT does not change, the resistance of the drain-source pad of both PD4 and PD5 decreases, so that, if the switch SW2 is open, i.e. the base of Q3 is not connected to VSS, Q3 and Q4 both become more conductive. Moreover, the decrease of the voltage at the drain of ND1 causes the voltage at the base of Q1 to decrease via PD3 and D1, whereby Q1 and Q2 become less conductive. As a result of Q1 and Q2 becoming less conductive and Q3 and Q4 becoming more conductive when the voltage at IN increases, the voltage at OUT decreases. Analogously, the voltage at OUT increases when the voltage at IN decreases.
To be noted that in the above the voltage at OUT was assumed to be constant, which is generally not the case in practice but does not alter the conclusions. Indeed, it constitutes a negative feedback, i.e. an increasing voltage at IN causes the voltage at OUT to decrease and thereby to give less bias to Q3 and Q4 and more bias to Q1 and Q2 so that the voltage at OUT decreases less than in the above theoretical example but nevertheless still decreases with an increasing voltage at IN.

When the voltage at IN is sufficiently high, Q1 and Q2 are completely cut off and a large voltage equal to VCC minus the voltage at OUT occurs across Q1 and Q2. Q3 and Q4 are then conducting and the voltage at OUT is determined by the voltage at IN and by the (not shown) load connected to OUT. A current then flows from the line connected to OUT mainly via Q3 and Q4 to VSS. It is noted here that this current is provided by VCC via the second transistor arrangement connected to the second line of the above two-wire line.

When, as it may occur, a current pulse is, capacitively or inductively, injected on the two-wire line, and when this pulse issues a current which is opposite to the current supplied to this two-wire line by the two transistor arrangements, then this current pulse is drawn from VCC to the line connected to OUT shown in Fig. 1 and flows to VSS via the second transistor arrangement. However, because Q1 and Q2 are cut off, this current is provided by ND2. Likewise, when Q3 and Q4 are cut off and current injected on the two-wire line has to flow to VSS, it flows via PD4.
To be noted that the current provided by current source PD1 is mirrored to ND2 by ND3 much like in a so-called current mirror well known in the art. The sources of ND2 and ND3 not being interconnected unlike in a current mirror, the current through ND2 is not only determined by the current through ND3 but also by the voltage at the source of ND2, i.e. the voltage at OUT.

When, as in the foregoing case, the voltage at IN is so high that Q1 and Q2 are completely cut off then a large voltage occurs over Q1 and Q2. Q1 and Q2 being cut off, the maximum voltage allowed to occur over Q1 is its so-called collector-emitter breakdown voltage with open base (BVCEO). Consequently, the voltage at OUT may not drop below VCC minus BVCEO of Q1 as long as SW1 is open. To be noted that the maximum voltage allowed over Q2 is its so-called collector emitter breakdown voltage with short-circuited base (BVCES) since, the darlington pair Q1/Q2 being cut off, i.e. Q1 being cut off, the base of Q2 is short-circuited to its emitter via R3. However, the sensing means of Fig. 2 is so designed that when the voltage between VCC and OUT exceeds a predetermined value, which is lower than BVCEO, then this sensing means causes SW1 to close so that the base of Q1 becomes connected to OUT. As a result, the maximum voltage across Q1 and Q2 may now increase to BVCES of Q1 (or more accurately to its collector emitter breakdown voltage with a resistance R between its emitter and its base (BVCER) where R is the low closed-switch resistance of SW1) which is higher than its BVCEO. To be noted that Q2 may be a transistor with a lower transistor current gain (beta) than Q1 so that its BVCES is higher than that of Q1. Likewise, when the voltage between OUT and VSS exceeds a predetermined value, which is lower than the BVCEO of Q3, then SW2 is closed by a sensing means similar to the one shown in Fig. 2.

The circuit shown in Fig. 2 operates as follows.

As long as the voltage between terminal COLL connected to the collectors of Q1/Q2 or Q3/Q4, and terminal EM connected to the emitter of Q2 or Q4 is lower than the zener voltage of ZD1, no current can flow through PS2 and the voltage at the cathode of ZD1 is equal to that at COLL so that PS3 is then cut off. As a result, the voltage at the gate of NS2 is equal to that at EM whereby also NS2 is cut off. Thus, the switch SW1 or SW2, constituted by NS2, is open. When the voltage between COLL and EM exceeds the sum of the zener voltages of ZD1, ZD2 and the forward voltage of about 0.7 volts over D2, then a current starts flowing through PS2, ZD1, ZD2, D2 and R3 so that the voltage at the gate of PS3 decreases. When this voltage is low enough, PS3 is no longer cut off and a current flows from COLL to EM via PS1, PS3 and R3. Thereby, the voltage at the gate of NS2 increases and, when it becomes sufficiently high, NS2 is no longer cut off so that the switch is closed. Also, NS1 is then no longer cut off so that the current flowing through PS2 and ZD1 now flows through NS1 instead of through ZD2, D2 and R3. Consequently, in order to close the switch again, the voltage between COLL and EM must decrease until below the zener voltage of ZD1, whereby no more current can flow through PS2, the voltage at the cathode of ZD1 becomes again equal to that of COLL, and PS3 is cut off again as is NS2.

Summarizing, the switch is closed at a voltage between COLL and EM of about the sum of the zener voltages of ZD1 and ZD2 and is reopened at a voltage of about the zener voltage of ZD1. In this way, a hysteresis is provided preventing the switch from repetitively opening and closing. To be noted that D2 prevents any current to flow from the gate of NS1 to its drain via ZD2 when the voltage at this gate is higher than that at this drain, thereby preventing ZD2 from being damaged by too large a current in that direction. Moreover, when ZD2 has a positive temperature coefficient, i.e. ZD2 is a so-called avalanche breakdown zener diode, then D2 provides temperature compensation for ZD2. A similar diode as D2 may also be provided for ZD1 but not when this is a true Zener diode, i.e. operating according to the so-called Zener-effect. Finally, the purpose of ZD3 is to avoid the voltage at the gate of NS2 to rise too high. It should also be noted that when SW1 is closed a reverse current pulse injected on the line may also be delivered by PD2 instead of only via ND2. Likewise, when SW2 is closed, a reverse current pulse may also sink to VSS via PD5 instead of only via PD4.

While the principles of the invention have been described above in connection with specific apparatus, it is to be clearly understood that this description is made only by way of example and not as a limitation on the scope of the invention which is defined by the appended claims.

## Claims

1. Transistor arrangement including a bipolar transistor means (Q1/Q2, Q3/Q4) a collector-emitter path of which is connected between a first terminal (VCC, OUT) and a second terminal (OUT, VSS), and a base of which is coupled to an input terminal (IN) driving said transistor arrangement, and a switching means (SW1, SW2) connected between said base and an emitter of said bipolar transistor means (Q1/Q2, Q3/Q4), characterized in that said transistor arrangement includes a sensing means coupled between between said first terminal (VCC, OUT) and said second terminal (OUT, VSS), and adapted to sense the voltage across said terminals and to close said switching means (SW1, SW2) immediately when said voltage exceeds a predetermined value, and an impedance means (PD1/ND2/ND3, PD4), coupled in parallel to said bipolar transistor means (Q1/Q2, Q3/Q4) between said first terminal (VCC, OUT) and said second terminal (OUT, VSS), and having an input whereto said input terminal (IN) is coupled, said impedance means (PD1/ND2/ND3, PD4) being adapted to allow current flow between said first terminal (VCC, OUT), said second terminal (OUT, VSS) and said input terminal (IN) at least when said voltage exceeds said predetermined value.

2. Transistor arrangement according to claim 1, characterized in that said impedance means (PD1/ND2/ND3) includes a first field effect transistor (PD1) whose drain-source path is coupled between said first terminal (VCC) and said second terminal (OUT) and a gate of which is biased so as to allow said current to flow.

3. Transistor arrangement according to claim 1, characterized in that said impedance means (PD4) includes a second field effect transistor (PD4) of which the drain-source path is coupled between said first terminal (OUT) and said second terminal (VSS) and of which a gate is coupled to said input terminal (IN) so as to allow said current to flow.

4. Transistor arrangement according to claim 1, characterized in that it further includes a third field effect transistor (PD2) connected between said collector and said base of said bipolar transistor means (Q1/Q2) and a gate of which is biased so as to allow said current to flow.

5. Transistor arrangement according to claim 1, characterized in that it further includes a fourth field effect transistor (PD5) connected between said collector and said base of said bipolar transistor means (Q3/Q4) and a gate of which is coupled to said input terminal (IN) so as to allow said current to flow.

6. Transistor arrangement according to claim 1, characterized in that said bipolar transistor means (Q1/Q2, Q3/Q4) includes a NPN transistor.

7. Transistor arrangement according to claim 1, characterized in that it further includes a second bipolar transistor means (Q3/Q4) a collector-emitter path of which is connected between said second terminal (OUT) and a third terminal (VSS), and a base of which is also coupled to said input terminal (IN), a second switching means (SW2) connected between said base and an emitter of said second bipolar transistor means (Q3/Q4), and a second sensing means sensing the voltage between said second terminal (OUT) and said third terminal (VSS) and closing said second switching means (SW2) when the latter voltage exceeds a second predetermined value, and a second impedance means (PD4) also connected between said second terminal (OUT) and said third terminal (VSS) and which is adapted to allow a current to flow from said second terminal (OUT) to said third terminal (VSS) when said voltage across the latter terminals exceeds said second predetermined value, and that said second terminal (OUT) constitutes an output of said transistor arrangement.

8. Transistor arrangement according to claim 1, characterized in that said sensing means includes a zener diode (ZD1) coupled in series with a resistor (R3) between said first terminal (VCC, OUT) and said second terminal (OUT, VSS), said resistor (R3) being coupled between said zener diode (ZD1) and said second terminal (OUT, VSS), and in that said first mentioned switching means (SW1, SW2) is constituted by a fifth field effect transistor (NS2) a gate of which is coupled to a coupling node between said resistor (R3) and said zener diode (ZD1).

9. Transistor arrangement according to claim 6, characterized in that a second zener diode (ZD2) is coupled between said coupling node and said first mentioned zener diode (ZD1), that a third switching means (NS1) is connected between said emitter and the junction point between said first zener diode (ZD1) and said second zener diode (ZD2), said third switching means (NS1) being closed when the voltage across said resistor (R3) exceeds a predetermined threshold value, and that a current mirror circuit (PS1, PS2, PS3) is provided to which the current flowing through said first zener diode (ZD1) is input and from which a mirrored current is output to said resistor (R3).

10. Transistor arrangement according to claim 7, characterized in that said third switching means (NS1) is constituted by a sixth field effect transistor a gate of which is connected to said coupling node.

## Patentansprüche

1. Transistoranordnung, die ein Bipolartransistormittel (Q1/Q2, Q3/Q4), von dem ein Kollektor-Emitter-Pfad zwischen einen ersten Anschluß (VCC, OUT) und einen zweiten Anschluß (OUT, VSS) geschaltet ist und von dem eine Basis mit einem Eingangsanschluß (IN) gekoppelt ist, der die Transistoranordnung antreibt, und ein zwischen die Basis und einen Emitter des Bipolartransistormittels (Q1/Q2, Q3/Q4) geschaltetes Schaltmittel (SW1, SW2) enthält, **dadurch gekennzeichnet,** daß die Transistoranordnung ein Erfassungsmittel, das zwischen den ersten Anschluß (VCC, OUT) und den zweiten Anschluß (OUT, VSS) gekoppelt ist und ausgelegt ist, die Spannung über den Anschlüssen zu erfassen und das Schaltmittel (SW1, SW2) unmittelbar dann, wenn die Spannung einen vorbestimmten Wert überschreitet, zu schließen und ein Impedanzmittel (PD1/ND2/ND3, PD4), das parallel zu dem Bipolartransistormittel (Q1/Q2, Q3/Q4) zwischen den ersten Anschluß (VCC, OUT) und den zweiten Anschluß (OUT, VSS) gekoppelt ist und einen Eingang aufweist, zu dem der Eingangsanschluß (IN) gekoppelt ist, wobei das Impedanzmittel (PD1/ND2/ND3, PD4) ausgelegt ist, das Fließen von Strom zwischen dem ersten Anschluß (VCC, OUT), dem zweiten Anschluß (OUT, VSS) und dem Eingangsanschluß (IN) zumindest dann zu ermöglichen, wenn die Spannung den vorbestimmten Wert überschreitet, enthält.

2. Transistoranordnung nach Anspruch 1, dadurch gekennzeichnet, daß das Impedanzmittel (PD1/ND2/ND3) einen ersten Feldeffekttransistor (PD1), dessen Drain-Source-Pfad zwischen den ersten Anschluß (VCC) und den zweiten Anschluß (OUT) gekoppelt ist und von dem ein Gate so vorgespannt ist, um zu ermöglichen, daß der Strom fließt, enthält.

3. Transistoranordnung nach Anspruch 1, dadurch gekennzeichnet, daß das Impedanzmittel (PD4) einen zweiten Feldeffekttransistor (PD4) enthält, dessen Drain-Source-Pfad zwischen den ersten Anschluß (OUT) und den zweiten Anschluß (VSS) gekoppelt ist und von dem ein Gate mit dem Eingangsanschluß (IN) gekoppelt ist, um zu ermöglichen, daß der Strom fließt.

4. Transistoranordnung nach Anspruch 1, dadurch gekennzeichnet, daß sie ferner einen dritten Feldeffekttransistor (PD2) enthält, der zwischen den Kollektor und die Basis des Bipolartransistormittels (Q1/Q2) geschaltet ist und von dem ein Gate so vorgespannt ist, um zu ermöglichen, daß der Strom fließt.

5. Transistoranordnung nach Anspruch 1, dadurch gekennzeichnet, daß sie ferner einen vierten Feldeffekttransistor (PD5) enthält, der zwischen den Kollektor und die Basis des Bipolartransistormittels (Q3/Q4) geschaltet ist und von dem ein Gate mit dem Eingangsanschluß (IN) gekoppelt ist, um zu ermöglichen, daß der Strom fließt.

6. Transistoranordnung nach Anspruch 1, dadurch gekennzeichnet, daß das Bipolartransistormittel (Q1/Q2, Q3/Q4) einen NPN-Transistor enthält.

7. Transistoranordnung nach Anspruch 1, dadurch gekennzeichnet, daß sie ferner ein zweites Bipolartransistormittel (Q3/Q4), von dem ein Kollektor-Emitter-Pfad zwischen den zweiten Anschluß (OUT) und einen dritten Anschluß (VSS) geschaltet ist und von dem eine Basis auch mit dem Eingangsanschluß (IN) gekoppelt ist, ein zweites Schaltmittel (SW2), das zwischen die Basis und einen Emitter des zweiten Bipolartransistormittels (Q3/Q4) geschaltet ist, und ein zweites Erfassungsmittel, das die Spannung zwischen dem zweiten Anschluß (OUT) und dem dritten Anschluß (VSS) erfaßt und das zweite Schaltmittel (SW2) schließt, wenn die letztere Spannung einen zweiten vorbestimmten Wert überschreitet, und ein zweites Impedanzmittel (PD4), das ebenfalls zwischen den zweiten Anschluß (OUT) und den dritten Anschluß (VSS) geschaltet ist und das ausgelegt ist, zu ermöglichen, daß ein Strom von dem zweiten Anschluß (OUT) zu dem dritten Anschluß (VSS) fließt, wenn die Spannung über den letzteren Anschlüssen den zweiten vorbestimmten Wert überschreitet, enthält, und daß der zweite Anschluß (OUT) einen Ausgang der Transistoranordnung bildet.

8. Transistoranordnung nach Anspruch 1, dadurch gekennzeichnet, daß das Erfassungsmittel eine Zenerdiode (ZD1), die in Reihe mit einem Widerstand (R3) zwischen dem ersten Anschluß (VCC, OUT) und dem zweiten Anschluß (OUT, VSS) geschaltet ist, enthält, wobei der Widerstand (R3) zwischen die Zenerdiode (ZD1) und den zweiten Anschluß (OUT, VSS) geschaltet ist, und daß das erste erwähnte Schaltmittel (SW1, SW2) von einem fünften Feldeffekttransistor (NS2) gebildet ist, von dem ein Gate mit einem Koppelknoten zwischen dem Widerstand (R3) und der Zenerdiode (ZD1) gekoppelt ist.

9. Transistoranordnung nach Anspruch 6, dadurch gekennzeichnet, daß eine zweite Zenerdiode (ZD2) zwischen den Koppelknoten und die erste erwähnte Zenerdiode (ZD1) gekoppelt ist, daß ein drittes Schaltmittel (NS1) zwischen den Emitter und den Anschlußpunkt zwischen der ersten Zenerdiode (ZD1) und der zweiten Zenerdiode (ZD2) geschaltet ist, und daß das dritte Schaltmittel (NS1) geschlossen ist, wenn die Spannung über dem Widerstand (R3) einen vorbestimmten Schwellenwert überschreitet, und daß ein Stromspiegelschaltkreis (PS1, PS2, PS3) vorgesehen ist, zu dem der Strom, der durch die erste Zenderdiode (ZD1) fließt, eingegeben wird und von dem ein gespiegelter Strom zu dem Widerstand (R3) ausgegeben wird.

10. Transistoranordnung nach Anspruch 7, dadurch gekennzeichnet, daß das dritte Schaltmittel (NS1) von einem sechsten Feldeffekttransistor, von dem ein Gate mit dem Koppelknoten verbunden ist, gebildet ist.

## Revendications

1. Montage de transistors comprenant un moyen de transistor bipolaire (Q1/Q2,Q3/Q4) dont le trajet entre collecteur et émetteur est monté entre une première borne (VCC, OUT) et une seconde borne (OUT, VSS), dont une base est reliée à une borne d'entrée (IN) attaquant ledit montage de transistors, et un moyen de commutation (SW1, SW2) monté entre ladite base et un émetteur dudit moyen de transistor bipolaire (Q1/Q2, Q3/Q4, caractérisé en ce que ledit montage de transistors comprend un moyen de détection monté entre ladite première borne (VCC, OUT) et ladite seconde borne (OUT, VSS) et destiné à détecter la tension entre lesdites bornes et à fermer ledit moyen de commutation (SW1, SW2) dès que ladite tension dépasse une valeur prédéterminée, et un moyen d'impédance (PD1/ND2/ND3, PD4), monté en parallèle avec ledit moyen de transistor bipolaire (Q1/Q2, Q3/Q4) entre ladite première borne (VCC, OUT) et ladite seconde borne (OUT, VSS), et ayant uen entrée à laquelle est reliée ladite borne d'entrée (IN), ledit moyen d'impédance (PD1/ND2/ND3, PD4) étant destiné à permettre la circulation du courant entre ladite première borne (VCC, OUT), ladite seconde borne (OUT, VSS) et ladite borne d'entrée (IN) au moins lorsque ladite tension dépasse ladite valeur prédéterminée.

2. Montage de transistors selon la revendication 1, caractérisé en ce que ledit moyen d'impédance (PD1/ND2/ND3) comprend un premier transistor à effet de champ (PD1) dont le trajet drain-source est monté entre ladite première borne (VCC) et ladite seconde borne (OUT) et dont une grille est polarisée de manière à permettre la circulation dudit courant.

3. Montage de transistors selon la revendication 1, caractérisé en ce que ledit moyen d'impédance (PD4) comprend un second transistor à effet de champ (PD4) dont le trajet drain-source est monté entre ladite première borne (OUT) et ladite seconde borne (VSS) et dont une grille est reliée à ladite borne d'entrée (IN) de façon à permettre la circulation dudit courant.

4. Montage de transistors selon la revendication 1, caractérisé en ce qu'il comprend en outre un troisième transistor à effet de champ (PD2) monté entre ledit collecteur et ladite base dudit moyen de transistor bipolaire (Q1/Q2) et dont une grille est polarisée de manière à permettre la circulation dudit courant.

5. Montage de transistors selon la revendication 1, caractérisé en ce qu'il comporte en outre un quatrième transistor à effet de champ (PD5) monté entre ledit collecteur et ladite base dudit moyen de transistor bipolaire (Q3/Q4) et dont une grille est reliée à ladite borne d'entrée (IN) de manière à permettre la circulation dudit courant.

6. Montage de transistors selon la revendication 1, caractérisé en ce que ledit moyen de transistor bipolaire (Q1/Q2, Q3/Q4) comprend un transistor NPN.

7. Montage de transistors selon la revendication 1, caractérisé en ce qu'il comporte en outre un second moyen de transistor bipolaire (Q3/Q4), dont le trajet collecteur-émetteur est monté entre ladite seconde borne (OUT) et une troisième borne (VSS), et dont une base est également reliée à ladite borne d'entrée (IN), le second moyen de commutation (SW2) monté entre ladite base et un émetteur dudit second moyen de transistor bipolaire (Q3/Q4), et un second moyen de détection détectant la tension entre ladite seconde borne (OUT) et ladite troisième borne (VSS) et fermant ledit second moyen de commutation (SW2) lorsque la dernière tension dépasse une seconde valeur prédéterminée, et un second moyen d'impédance (PD4) également monté entre ladite seconde borne (OUT) et ladite troisième borne(VSS) et qui est destiné à permettre la circulation d'un courant entre ladite seconde borne (OUT) et ladite troisième borne (VSS) lorsque ladite tension présente entre ces dernières bornes dépasse ladite seconde valeur prédéterminée, et en ce que ladite seconde borne (OUT) constitue une sortie dudit montage de transistors.

8. Montage de transistors selon la revendication 1, caractérisé en ce que ledit moyen de détection comprend une diode Zener (ZD1) montée en série avec une résistance (R3) entre ladite première borne (VCC, OUT) et ladite seconde borne (OUT, VSS), ladite résistance (R3) étant montée entre ladite diode Zener (ZD1) et ladite seconde borne (OUT, VSS), et en ce que ledit moyen de commutation mentionné en premier (SW1, SW2) est constitué par un cinquième transistor à effet de champ (NS2), dont la grille est reliée à un noeud de couplage entre ladite résistance (R3) et ladite diode Zener (ZD1).

9. Montage de transistors selon la revendication 6, caractérisé en ce qu'une seconde diode Zener (ZD2) est montée entre ledit noeud de couplage et ladite diode Zener mentionnée en premier (ZD1), en ce qu'un troisième moyen de commutation (NS1) est monté entre ledit émetteur et le point de jonction entre ladite première diode Zener (ZD1) et ladite seconde diode Zener (ZD2), ledit troisième moyen de commutation (NS1) étant fermé lorsque la tension aux bornes de ladite résistance (R3) dépasse une valeur de seuil prédéterminée, et en ce qu'un circuit à courant en rapport géométrique (PS1, PS2, PS3) est fourni auquel le courant traversant ladite première diode Zener (ZD1) est appliqué et à partir duquel un courant en rapport géométrique est sorti pour application à ladite résistance (R3).

10. Montage de transistors selon la revendication 7, caractérisé en ce que ledit troisième moyen de commutation (NS1) est constitué par un sixième transistor à effet de champ dont la grille est reliée audit noeud de couplage.
